# EUROPÄISCHE PATENTSCHRIFT

(11) **EP 0 848 260 B1**
(45) Veröffentlichungstag und Bekanntmachung des Hinweises auf die Patenterteilung: **09.06.2004**
(21) Anmeldenummer: 97119274.5
(22) Anmeldetag: 04.11.1997
(51) Int. Cl.: G01R 31/01, G01R 31/28

(54) **Prüfplatz für elektronische Baueinheiten, insbesondere Mobilfunktelefone**
Test station for electronic devices, in particular mobile telephones
Station de test pour appareils électriques, en particulier des téléphones mobiles

(30) Priorität: 13.12.1996 DE 19652035
(43) Veröffentlichungstag der Anmeldung: 17.06.1998
(73) Patentinhaber: Rohde & Schwarz GmbH & Co. KG, D-81671 München (DE)
(72) Erfinder: Böhler, Erwin, 81737 München (DE)
(74) Vertreter: Körfer, Thomas, Dipl.-Phys.

(56) Entgegenhaltungen:
- WO-A-92/04989
- DE-A- 4 311 910
- US-A- 4 831 540

## Beschreibung

Die Erfindung betrifft einen Prüfplatz zum automatischen Prüfen von elektronische Baueinheiten wie Mobilfunktelefone laut Oberbegriff des Hauptanspruches.

Bei der Endprüfung von elektronischen Baueinheiten müssen im Prüffeld an einem Prüfplatz Kontrollmessungen und Abgleicharbeiten durchgeführt werden. Zur Endprüfmessung von Mobilfunktelefonen ist es beispielsweise bekannt, die Prüflinge einzeln oder mehrere gleichzeitig mittels einer Transporteinrichtung auf einem Warenträger einer Adapterstation zuzuführen, die Prüflinge dort mit einem Adapter zu kontaktieren und über ein mit dem Adapter verbundenes Meßsystem zu vermessen bzw. abzugleichen. Bei einem Produktwechsel der Prüflinge muß sowohl der Warenträger, der für den Transport mit den Prüflingen bestückt wird, als auch der Adapter in der Adapterstation ausgewechselt werden, gleichzeitig muß das Meßsystem meist neu kalibriert werden. Dieses bekannte Prüfverfahren ist sehr zeitaufwendig und auch fehleranfällig, außerdem müssen für verschiedene Prüflinge jeweils unterschiedliche Warenträger und Adapter auf Lager gehalten werden. Eine Durchsatzerhöhung ist bei dem bekannten System nur durch Duplizierung der Prüfplätze möglich, also nur mit erhöhtem Platzbedarf.

Aufgabe der Erfindung ist es, einen Prüfplatz zu schaffen, der sehr kurze Meßzeiten ermöglicht, schnell auf die Prüfung unterschiedlicher Prüflinge umrüstbar ist und trotzdem eine zuverlässige automatische Prüfung bei geringstem Platzbedarf ermöglicht.

Diese Aufgabe wird ausgehend von einem Prüfplatz laut Oberbegriff des Hauptanspruches durch dessen kennzeichende Merkmale gelöst, vorteilhafte Weiterbildungen insbesondere auch bezüglich eines besonders vorteilhaften Verfahrens zum Prüfen von elektronischen Baueinheiten mittels eines solchen Prüfplatzes ergeben sich aus den Unteransprüchen.

Bei dem erfindungsgemäßen Prüfplatz können bereits während der Transportphase und Wartephase der Prüflinge, also auf ihrem Transport zur eigentlichen Adapterstation, vorbereitende Messungen durchgeführt werden, beispielsweise können während des Transportes über den warenträgereigenen Steuerrechner die Prüflinge eingeschaltet und an ihnen ein Selbsttest durchgeführt werden. Außerdem kann über zwischengeschaltete Analog/Digital-Wandler die Stromaufnahme der im Einsatz des Warenträgers abgelegten Prüflinge gemessen werden. Beim Prüfen von Mobilfunktelefonen könnte über den Steuerrechner auch ein Verbindungsaufbau zwischen den im Einsatz abgelegten Mobilfunktelefonen und einer externen oder internen Basisstation im Gebäude gestartet werden. Durch diese vorbereitenden Messungen während der Transportphase sind extrem kurze Prüfzeiten möglich und zwar ohne zusätzlichen Platzbedarf. Der Prüfplatz kann auch auf einfache Weise in kürzester Zeit auf andere Prüflinge oder Prüflingsvarianten umgerüstet werden, besitzt also hohe Flexibilität und trotzdem eine hohe Zuverlässigkeit im automatischen Betrieb. Der standardisierte Warenträger ist für beliebige Prüflingsvarianten geeignet, es ist nur erforderlich, den prüflingsspezifischen Einsatz zu wechseln. Zur Vermeidung von Reflexionen in der Hochfrequenz-Schirmkammer der Adapterstation ist der Warenträger selbst aus Kunststoff hergestellt und der dort angebrachte Steuerrechner mit einer entsprechenden Hochfrequenzabschirmung versehen. In die Verbindungsleitungen zwischen den Prüflingen im Einsatz und dem Steuerrechner sind entsprechende Filter eingebaut. Dadurch werden Meßfehler durch die am Warenträger vorgesehene Elektronik beim Messen in der Adapterstation verhindert.

Die Verbindung zwischen Steuerrechner und dem Meßsystem in der Adapterstation erfolgt in bekannter Weise beispielsweise über eine Infrarot- oder Hochfrequenzverbindung oder durch entsprechende Kontakstifte. Über die ausgangsseitige Schnittstelle des Steuerrechners ist in der Adapterstation ein Datenaustausch zwischen den im Warenträger abgelegten Prüflingen und dem stationären Meßsystem gewährleistet. Die ausgangsseitige Schnittstelle ist standardisiert und ermöglicht sowohl innerhalb als auch außerhalb der Adapterstation eine entsprechende Verbindung zu Meß- oder Steuersystemen. Auch die eingangsseitige Schnittstelle des Steuerrechners, mit welcher die Prüflingen verbunden sind, ist standardisiert und mit dem prüflungsspezifischen Einsatz verdrahtet.

Zusätzlich zum Steuerrechner ist an jedem Warenträger vorzugsweise noch ein Identifikationschip vorgesehen, der drahtlos beispielsweise über eine Hochfrequenzverbindung die Identifikation der einzelnen Warenträger ermöglicht. Jeder Warenträger kann je nach den von ihm aufgenommenen Prüflingen entsprechend unterschiedlich codiert sein. Das Nachladen der Warenträgerbatterie, mit welcher der Steuerrechner und während der Vorprüfung auch die Prüflinge gespeist sind, erfolgt über am Warenträger vorgesehene Kontakte beispielsweise innerhalb der Adapterstation, in der Warteposition vor der Adapterstation oder in dem die unbestückten Warenträger aufnehmenden Warenträgerspeicher.

Der Ladezustand des Akkus wird vom Steuerrechner laufend überprüft und über Leuchdioden (z.B. grün/rot ) angezeigt, die gut sichtbar am Warenträger angebracht sind. Dadurch kann das Bedienpersonal optisch erkennen, ob der Warenträger funktionsfähig ist und mit neuen Prüflingen bestückt werden darf. Alternativ kann die Akkuspannung auch automatisch auf dem Rücktransportweg des Warenträgers gemessen werden und im Fehlerfall lässt sich der betreffende Warenträger über eine Weiche in den Warenträgerspeicher umleiten, so daß er nicht versehentlich weiterverwendet wird.

Der Steuerrechner enthält ein EEPROM, welches die Anzahl der Kontaktierungen des Warenträgers hochzählt. Damit kann die Betriebsdauer des Warenträgers überwacht werden und Verschleißteile des Adapters wie die Kontaktschnittstelle zu den Prüflingen sind in fest vorgebbaren Zyklen vorbeugend austauschbar. Dieses EEPROM kann auch warenträgerspezifische Korrekturwerte, wie die Pfad-Kompensation der HF-Kabel, enthalten, die bei der Messung zu berücksichtigen sind.

Die Erfindung wird im folgenden anhand schematischer Zeichnungen an einem Ausführungsbeispiel näher erläutert.

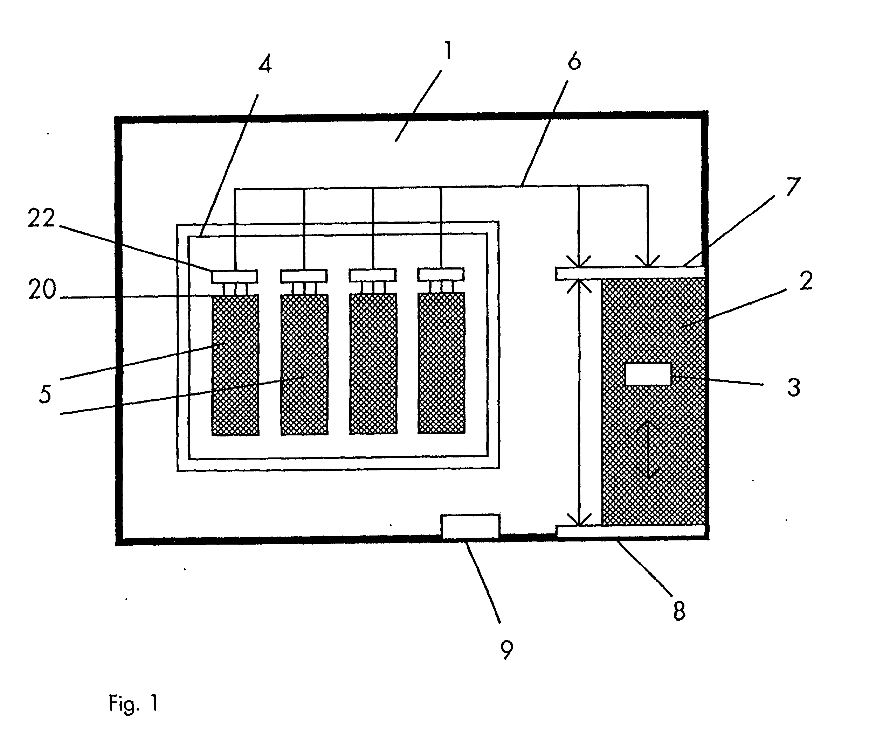

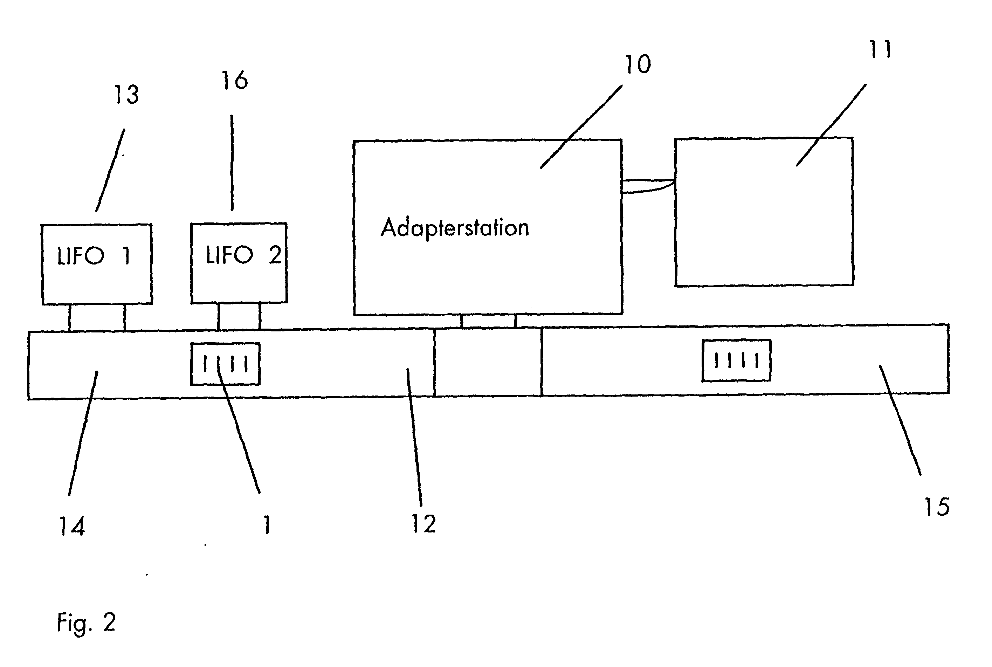

Fig. 1 zeigt die Draufsicht auf einen Warenträger 1, der bei einem Prüfplatz nach Fig. 2 zum automatischen Prüfen von Mobilfunktelefonen eingesetzt wird. Der Warenträger 1 besteht aus Kunststoff und ist ähnlich wie ein Tablett ausgebildet. An ihm ist ein Steuerrechner 2 angebracht, der über einen Akku 3 gespeist ist. Am Warenträger 1 ist außerdem ein Einsatz 4 angebracht, der prüflingsspezifisch ausgebildet ist und für die Aufnahme von mehreren in dem gezeigten Ausführungsbeispiel für vier nebeneinander angebrachte Mobilfunktelefone 5 vorgesehen ist. Die Meßkontakte 20 der Mobilfunktelefone 5, an denen vorbestimmte Kontrollmessungen durchgeführt werden sollen, und die Batteriespeisekontakte, Antennenkontakte und eventuelle weitere Steuerkontakte stehen mit am Einsatz 4 prüflingsspezifisch ausgebildeten Kontakten 22 in Verbindung, die ihrerseits über fest verdrahtete Verbindungsleitungen 6 mit der standardisierten Eingangsschnittstelle 7 des Steuerrechners 2 verbunden sind.

Am Rand des Steuerrechners 2 ist eine standardisierte Ausgangsschnittstelle 8 vorgesehen, die über eine kontaktlose Infrarot-oder Hochfrequenz-Verbindung oder über mechanische Kontaktstifte mit einer entsprechenden Schnittstelle in der in Fig. 2 dargestellten Adapterstation 10 verbindbar ist, die ihrerseits die Verbindung mit dem eigentlichen Meßsystem 11 herstellt.

Der in Fig. 2 dargestellte Prüfplatz besteht aus einem Transportband 12, auf das in der Bestückungsstation die beispielsweise in einem Lift 13 übereinander gestapelten unbestückten Warenträger 1 aufgelegt werden. In der Bestückungsstation 14 werden die zu messenden Mobilfunktelefone in den Einsatz der Warenträger 1 abgelegt und die Warenträger werden dann durch das Transportband zur Adapterstation 10 transportiert. In der Adapterstation wird die Verbindung zwischen der ausgangsseitigen Schnittstelle 8 des Steuerrechners 2 und dem Meßsystem 11 hergestellt und über den Datenaustausch zwischen den Mobilfunktelefonen und dem Meßsystem 11 werden die Mobilfunktelefone gemessen und abgeglichen. Nach dem Messen werden die Warenträger 1 über das Transportband 12 der Entnahme- und Verpackungsstation 15 zugeführt, in welcher die Mobilfunktelefone aus dem Einsatz 4 herausgenommen und die leeren Warenträger wieder dem Speicher 13 zugeführt werden. Während des schrittweisen Transportes der Warenträger von der Bestükkungsstation 14 zur Adapterstation 10 und während der jeweiligen dazwischenliegenden Wartezeiten werden über den Steuerrechner 2 vorbereitende Messungen durchgeführt, wobei die Mobilfunktelefone über den Akku 3 gespeist werden. Die Adapterstation 10 ist auf die standardisierten Warenträger und die standardisierte Schnittstelle 8 abgestimmt und somit nicht prüflingsspezifisch ausgebildet, die Anpassung an die unterschiedlichen Prüflinge übernimmt der Warenträger 1. Auf diese Weise reichen beispielsweise je Produktvariante ca. 15 Warenträger 1 aus, deren Einsätze 4 jeweils produktspezifisch ausgebildet sind und in einem Liftspeicher 13 gespeichert sind. Gemäß Fig. 2 ist es vorteilhaft, einen oder mehrere weitere zusätzliche solche Liftspeicher 16 vorzusehen, die zum Abspeichern der standardisierten Warenträger 1 ausgebildet sind, wobei die Warenträger jedoch jeweils Einsätze 4 für andere zu prüfende Produkte aufweisen.

Bei einem Produktionswechsel sind zunächst die leeren Warenträger des Produktes A in den Speicher 13 zurückzufahren. Anschließend sind die Warenträger des Produktes B aus dem Speicher 16 zur Bestückungsstation 14 abzugeben, so daß in kürzester Umrüstzeit von einer Prüfung der Produkte A auf Prüfung der Produkte B umgestellt werden kann.

Auf den einzelnen Warenträgern 1 sind vorzugsweise noch Identifizierungschips oder Barcodestreifen 9 angebracht, deren Codierung in der Adapterstation 10 drahtlos auslesbar ist. Durch unterschiedliche Codierung der einzelnen Warenträger ist damit auch ein gemischter Test von Produkten A und Produkten B möglich, da in der Adapterstation erkennbar ist, welche Produkte gerade über einen Warenträger der Adapterstation zugeführt werden. Das Meßsystem 11 kann dann sofort das Prüfprogramm auf das jeweilige Produkt automatisch umschalten. Damit ist eine große Flexibilität der Produktionslinie erreichbar, eine manuelle Umrüstung wie in bisherigen Produktionsystem ist nicht notwendig.

Es ist notwendig, die Adapterstation in regelmäßigen Abständen zu kalibrieren, andernfalls könnten vor allem durch Drift der HF-Parameter die Prüflinge fehlerhaft gemessen und abgeglichen werden. Zu diesem Zweck ist für jeden Prüflingstyp ein spezieller Kalibrier-Warenträger vorgesehen, der Meßantennen und präzise HF-Leistungmesser enthält. Um die Komplexität der Kalibrier-Warenträger zu verringern, werden die zu kalibrierenden Funktionen und Parameter z.B. auf zwei Warenträger aufgeteilt.

Ein erster Kalibrierwarenträger für Video/Audio und Keyboard enthält z.B.
ein Video-Referenzbild,
ein Audio-Meßmikrofon und Norm-Lautsprecher,
Keyboard Referenztasten und eine
Selbsttest-Schnittstelle mit Brücken und Testsignalen.

Ein zweiter Kalibierwarenträger enthält z.B.
HF-Kontakt für HF-Leistungsmesser,
eine HF-Antenne für HF-Leistungsmessung und eine
Selbsttest-Schnittstelle mit Brücken und Testssigalen.

Der Kalibrier-Warenträger befindet sich normalerweise im Warenträgerspeicher. Er wird über die Transporteinrichtung, gesteuert durch die System-Software, in frei einstellbaren Intervallen in die Adapterstation geleitet. Die System-Software erkennt diesen Warenträger anhand einer speziellen Codierung und kann auf eine Kalibrierroutine umschalten.

Die ermittelten Kalibrier-Parameter werden dann in der System-Software gespeichert und bei den nachfolgenden Messungen für die Meßwertkorrektur verwendet.

Gleichzeitig ist mit diesem Kalibrier-Warenträger ein Selbsttest zwischen der elektischen Schnittstelle des Warenträgers und dem Meßsystem möglich. Damit können Kabelfehler und Fehler der Meßgeräte lokalisiert werden.
Dieser Kalibrier- und Selbsttestvorgang läuft vollautomatisch ab, ohne manuellen Eingriff oder Umrüstung durch das Bedienpersonal.

Zur Erhöhung der Linienkapazität werden mehrere Adapterstationen parallel betrieben und über ein Transportsystem miteinander verbunden.

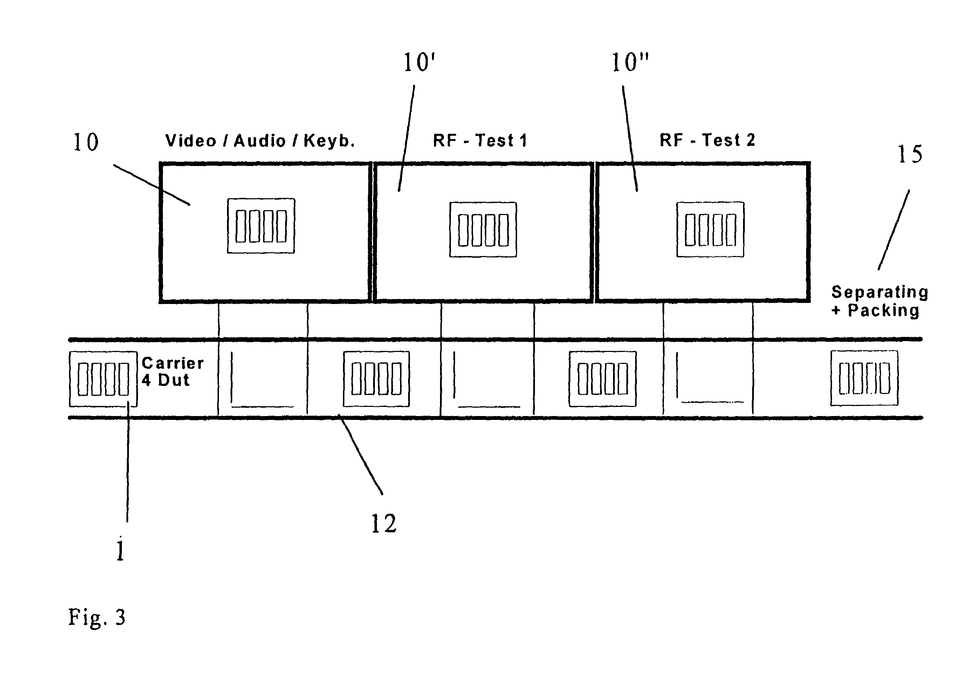

Diese Adapterstationen 10. 10' und 10" können entweder gemäß Fig. 3 in einer Ebene nebeneinanger angeordnet oder zur Minimierung der erforderlichen Standfläche übereinander gestapelt werden, wobei die Warenträger mit den Prüflingen dann über einen Lift zugeführt werden.

Beim Test von Mobiltelefonen ist eine Aufteilung der Tests in eine Adapterstation für HF-Messungen und eine Adapterstation für Display/Audio und Keyboardtest erforderlich. Die geschirmte Adapterstation für HF-Messungen darf im Innenraum möglichst wenige mechanische Komponenten enthalten. Diese würden zu Feldverzerrungen bzw. Reflexionen und damit zu Meßund Abgleichfehlern führen. Deswegen ist für den Displaytest, den Audiotest und den Keyboardtest eine getrennte Adapterstation vorgesehen.

In der Rücktransportebene der leeren Warenträger befindet sich eine Selbsttesteinrichtung, bestehend aus einem XYZ-Handler mit Prüfstift, der mit einer Testeinrichtung elektrisch verbunden ist. Die Testeinrichtung steuert die XYZ-Bewegung des Prüfstiftes, speist über die standardisierte Schnittstelle 8 Testsignale ein und vergleicht das elektrische Signal vom Prüfstift mit dem Sollwert. Der Steuerrechner wird ebenfalls über die Schnittstelle 8 durch Einspeisung geeigneter Testsignale überprüft. Auf diese Weise können Verdrahtungsfehler des Warenträgers und unterbrochene Leitungen oder defekte Prüfspitzen auf dem Warenträger festgestellt werden und es kann der Akku-Ladezustand und der Zustand der HF-Kabel geprüft werden.

## Patentansprüche

1. Prüfplatz für elektronische Baueinheiten (5), insbesondere für Mobilfunktelefone, bei dem die Prüflinge auf einem Warenträger (1) mittels einer Transporteinrichtung (12) einer Adapterstation (10) zugeführt und dort über ein mit dem Adapter verbundenes Meßsystem (11) geprüft werden, **dadurch gekennzeichnet, daß** jeder Warenträger (1) einen eigenen batteriebetriebenen Steuerrechner (2) und einen Einsatz (4) zur Aufnahme von einem oder mehreren Prüflingen (5) aufweist, am Prüflingseinsatz (4)prüflingsspezifische Kontakte vorgesehen sind, die mit der Eingangsschnittstelle (7) des Steuerrechners (2) verbunden sind, und in der Adapterstation (10) eine zu der standardisierten Ausgangsschnittstelle (8) des Steuerrechners (2) passende Verbindung zum Meßsystem (11) vorgesehen ist.

2. Prüfplatz nach Anspruch 1, **dadurch gekennzeichnet, daß** der Wartenträger (1) aus Kunststoff besteht.

3. Prüfplatz nach Anspruch 1 oder 2, **dadurch gekennzeichnet, daß** an jedem Warenträger (1) eine codierbare, drahtlos auslesbare Identifikationseinrichtung (9) vorgesehen ist.

4. Prüfplatz nach einem der vorhergehenden Ansprüche, **dadurch gekennzeichnet, daß** die den Steuerrechner (2) speisende Batterie (3) gleichzeitig zur Speisung der im Einsatz (4) aufgenommenen Prüflinge (5) dient.

5. Prüfplatz nach einem der vorhergehenden Ansprüche, **dadurch gekennzeichnet, daß** längs der Transporteinrichtung (12) mindestens eine Stapeleinrichtung (13,16) für Warenträger (1) vorgesehen ist, aus der die Warenträger einzeln zur Bestückungsstation der Transporteinrichtung (12) zuführbar sind.

6. Prüfplatz nach einem der vorhergehenden Ansprüche, **dadurch gekennzeichnet, daß** in der Adapterstatition(10) und/oder längs der Transporteinrichtung (12) und/oder in der Warenträger/Stapeleinrichtung (13,16) Einrichtungen zum Nachladen der Wartenträger-Batterie (3) vorgesehen sind.

7. Prüfplatz nach einem der vorhergehenden Ansprüche, **dadurch gekennzeichnet, daß** der Steuerrechner (2) als austauschbare Moduleinheit ausgebildet ist.

8. Prüfplatz nach einem der vorhergehenden Ansprüche, **dadurch gekennzeichnet, daß** spezielle Kalibrier-Warenträger vorgesehen sind, auf denen prüflingsspezifische Kalibrierstandards für die Adapterstation angebracht sind.

9. Prüfplatz nach einem der vorhergehenden Ansprüche, **dadurch gekennzeichnet, daß** längs des Rücktransportweges der leeren Warenträger (1) eine Selbsttesteinrichtung zum Prüfen der Verdrahtung und/oder der elektronischen Bauelemente des Warenträgers vorgesehen ist.

10. Prüfplatz nach einem der vorhergehenden Ansprüche, **dadurch gekennzeichnet, daß** im Steuerrechner (2) ein Zähler vorgesehen ist, mit welchem die Anzahl der auf einanderfolgenden Kontaktierungen des Warenträgers (1) mit Prüflingen (5) gezählt wird.

11. Verfahren zum Prüfen von elektronischen Baueinheiten, insbesondere Mobilfunktelefonen, mittels eines Prüfplatzes nach einem der vorhergehenden Ansprüche 1 bis 10, **dadurch gekennzeichnet, daß** während des Transportes der Prüflinge (5) zur Adapterstation (10) gesteuert über den Steuerrechner (2) des jeweiligen Warenträgers (1) vorbereitende Messungen und/oder Tests an den Prüflingen (5) durchgeführt werden.

## Claims

1. Test station for electronic assembly units (5), especially for mobile telephones, wherein the devices under test (DUT) are conveyed on a product carrier (1) by means of a transport system (12) to an adapter station (10) where they are tested by a measuring system (11) connected to the adapter, **characterised in that** each product carrier (1) provides its own battery-operated control computer (2) and an insert (4) designed to accommodate one or more devices under test (5); that the insert (4) provides product-specific contacts connected to the input port (7) of the control computer (2); and that the adapter station (10) provides a connection to the measuring system (11) compatible with the standardised output port (8) of the control computer (2).

2. Test station according to claim 1, **characterised in that** the product carrier (1) is made from a synthetic material.

3. Test station according to claim 1 or 2, **characterised in that** an encodable identification component (9), which can be read in a wireless manner, is provided on every product carrier (1).

4. Test station according to any one of the preceding claims, **characterised in that** the battery (3) supplying the control computer (2) is used at the same time to supply the devices under test (5) accommodated in the insert (4).

5. Test station according to any one of the preceding claims, **characterised in that** at least one stacking unit (13, 16) for the product carriers (1) is provided along the transport system (12), from which the product carriers can be individually supplied to the loading station of the transport system (12).

6. Test station according to any one of the preceding claims, **characterised in that** equipment is provided in the adapter station (10) and/or along the transport system (12) and/or in the product carrier/stacking unit (13, 16) for recharging the product-carrier battery (3).

7. Test station according to any one of the preceding claims, **characterised in that** the control computer (2) is designed as a replaceable module.

8. Test station according to any one of the preceding claims, **characterised in that** special calibration product carriers are provided, to which product-specific calibration standards for the adapter station are attached.

9. Test station according to any one of the preceding claims, **characterised in that** a self-testing device is provided along the return transport pathway for empty product carriers (1) for testing the wiring and/or the electronic components of the product carrier.

10. Test station according to any one of the preceding claims, **characterised in that** a counter is provided in the control computer (2), which counts the number of successive contacts of the product carrier (1) with devices under test (5).

11. Method for testing electronic assembly units, especially mobile telephones, by means of a test station according to any one of the preceding claims 1 to 10, **characterised in that**, during the transport of the devices under test (5) to the adapter station (10), preparatory measurements and/or tests on the devices under test (5) are implemented in the relevant product carrier under the control of the control computer (2).

## Revendications

1. Station de test pour appareils électroniques (5), en particulier des radiotéléphones mobiles, où les échantillons sont amenés sur un support de produit (1) au moyen d'une installation de transport (12) à une station d'adaptateur (10) et y sont vérifiés par un système de mesure (11) relié à l'adaptateur, **caractérisée en ce que** chaque support de produit (1) présente un calculateur de commande propre (2) à batterie et un insert (4) pour la réception d'un ou plusieurs échantillons (5), que sont prévus à l'insert d'échantillon (4) des contacts spécifiques aux échantillons qui sont reliés à l'interface d'entrée (7) du calculateur de commande (2), et qu'il est prévu dans la station d'adaptateur (10) une connexion au système de mesure (11) adaptée à l'interface de sortie normalisé (8) du calculateur de commande (2).

2. Station de test selon la revendication 1, **caractérisée en ce que** le support de produit (1) est réalisé en matériau synthétique.

3. Station de test selon la revendication 1 ou 2, **caractérisée en ce qu'**il est prévu à chaque support de produit (1) une installation d'identification (9) pouvant être codée, lisible sans fil.

4. Station de test selon l'une des revendications précédentes, **caractérisée en ce que** la batterie (3) alimentant le calculateur de commande (2) sert en même temps à alimenter les échantillons (5) reçus dans l'insert (4).

5. Station de test selon l'une des revendications précédentes, **caractérisée en ce qu'**il est prévu le long de l'installation de transport (12) au moins une installation d'empilage (13,16) pour des supports de produit (1), à partir de laquelle les supports de produit peuvent être amenés individuellement à la station d'équipement de l'installation de transport (12).

6. Station de test selon l'une des revendications précédentes, **caractérisée en ce que** sont prévus dans la station d'adaptateur (10) et/ou le long de l'installation de transport (12) et/ou dans l'installation de support de produit/d'empilage (13,16) des installations pour recharger la batterie (3) des supports de produit.

7. Station de test selon l'une des revendications précédentes, **caractérisée en ce que** le calculateur de commande (2) est réalisé comme unité modulaire échangeable.

8. Station de test selon l'une des revendications précédentes, **caractérisée en ce que** des supports de produit de calibrage spéciaux sont prévus sur lesquels sont disposés des standards de calibrage spécifiques à l'échantillon pour la station d'adaptateur.

9. Station de test selon l'une des revendications précédentes, **caractérisée en ce qu'**il est prévu le long du chemin de retour des supports de produit vides (1), une installation de test automatique pour vérifier la câblage et/ou les composants électroniques du support de produit.

10. Station de test selon l'une des revendications précédentes, **caractérisée en ce qu'**il est prévu dans le calculateur de commande (2) un compteur au moyen duquel est compté le nombre des contacts successifs du support de produit (1) avec des échantillons (5).

11. Procédé de vérification d'appareils électroniques, en particulier de radiotéléphones mobiles, au moyen d'une station de test selon l'une des revendications précédentes 1 à 10, **caractérisé en ce que** pendant le transport des échantillons (5) à la station d'adaptateur (10), des mesures et/ou tests préparatoires sont effectués aux échantillons (5), en étant commandés par le calculateur de commande (2) du support de produit respectif (1).
